(19) Europäisches Patentamt
European Patent Office
Office européen des brevets

(11) EP 3 929 258 A1

(12) **EUROPEAN PATENT APPLICATION**

(43) Date of publication:
**29.12.2021 Bulletin 2021/52**

(21) Application number: **21180458.8**

(22) Date of filing: **18.06.2021**

(51) Int Cl.:
***C09J 7/35*** *(2018.01)* ***C09J 7/10*** *(2018.01)*
***C08K 7/18*** *(2006.01)* ***H01L 23/00*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.06.2020 JP 2020109065**
**20.01.2021 JP 2021007112**

(71) Applicant: **NITTO DENKO CORPORATION**
**Ibaraki-shi**
**Osaka 567-8680 (JP)**

(72) Inventors:
- **KOJIMA, Rena**
  **Osaka, 567-8680 (JP)**
- **ICHIKAWA, Tomoaki**
  **Osaka, 567-8680 (JP)**

(74) Representative: **Stolmár & Partner**
**Patentanwälte PartG mbB**
**Blumenstraße 17**
**80331 München (DE)**

(54) **THERMOSETTING SHEET AND DICING DIE BONDING FILM**

(57) A thermosetting sheet according to the present invention includes: a thermosetting resin; a thermoplastic resin; and conductive particles. The conductive particles includes silver particles having an average particle size $D_{50}$ of 0.01 μm or more and 10 μm or less, and having a circularity in cross section of 0.7 or more. The thermosetting sheet has a viscosity at 100 °C of 20 kPa·s or more and 3000 kPa·s or less.

**FIG. 1**

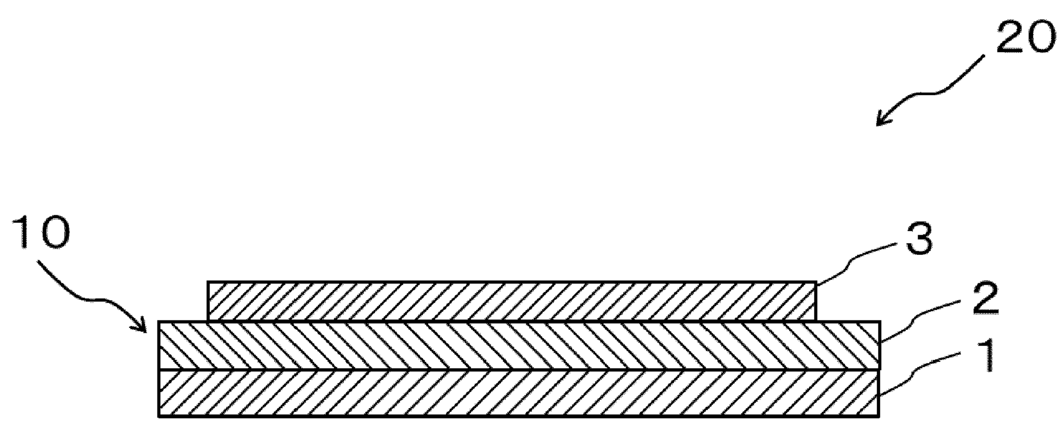


EP 3 929 258 A1

## Description

FIELD OF THE INVENTION

The present invention relates to a thermosetting sheet and a dicing die bonding film.

BACKGROUND OF THE INVENTION

There is conventionally known a method (die bonding method) for bonding a semiconductor device to an adherend such as a metal lead frame in producing a semiconductor apparatus using a thermosetting sheet (for example JP 2019-021813 A). JP 2019-021813 A discloses a thermosetting sheet including conductive particles and a thermosetting resin.

In such a method, for example, a semiconductor wafer and the thermosetting sheet attached to one side (i.e., a surface opposite to a circuit forming surface) of the semiconductor wafer are diced to thereby obtain a plurality of thermosetting sheets each having one side to which a semiconductor device is attached. The thermosetting sheet having the one side to which a semiconductor device is attached has the other side temporarily bonded to an adherend such as a metal lead frame at a specific temperature (for example 70 °C), followed by being subjected to heat curing at a higher temperature (for example 200 °C) to be thereby bonded to the adherend. That is, the semiconductor device is bonded to the adherend with the thermosetting sheet interposed therebetween.

SUMMARY OF THE INVENTION

Technical Problem

In the state where the thermosetting sheet having the one side to which the semiconductor device is attached is bonded to the adherend, there are some cases where the semiconductor device is separated from the thermosetting sheet. Such a separation is not preferable as it results in insufficient electric conduction and thermal conduction via the conductive particles. The separation is more likely to occur (i.e., the semiconductor device is more likely to come off from the thermosetting sheet) during the dicing of the semiconductor wafer and the thermosetting sheet. Nevertheless, no sufficient consideration appears to have been made on suppressing the separation of the semiconductor device from the thermosetting sheet.

In the case where a power semiconductor device is used in a semiconductor apparatus, the power semiconductor device is used with as large power as several MVA or more, consequently generating a large amount of heat. Thus, in the case where the thermosetting sheet as above is used for a power semiconductor device, the thermosetting sheet that has been bonded to the adherend, that is, the cured thermosetting sheet, preferably has high heat dissipation.

The problem of heat generation as aforementioned also occurs in the case where a semiconductor device other than a power semiconductor device is used; however, no sufficient consideration appears to have been made on improving heat dissipation of the cured thermosetting sheet, either.

It is therefore an object of the present invention to provide a thermosetting sheet capable of relatively suppressing the separation of the semiconductor device and having a relatively high heat dissipation after being cured, and a dicing die bonding film including the thermosetting sheet.

Solution to Problem

A thermosetting sheet according to the present invention includes: a thermosetting resin; a thermoplastic resin; and conductive particles, in which the conductive particles include silver particles having an average particle size $D_{50}$ of 0.01 $\mu$m or more and 10 $\mu$m or less, and having a circularity in cross section of 0.7 or more, the thermosetting sheet having a viscosity at 100 °C of 20 kPa·s or more and 3000 kPa·s or less.

In the thermosetting sheet, it is preferable that a packing ratio P of the conductive particles in the cured thermosetting sheet be 30 volume % or more.

In the thermosetting sheet, it is preferable that a thermal conductivity after being cured be 3 W/m·k or more.

In the thermosetting sheet, it is preferable that a peel strength from a silicon wafer at room temperature be 1 N/10 mm or more.

It is preferable that the thermosetting sheet include a volatile component, and that the volatile component include one or more hydroxy groups and have a boiling point of 250 °C or more.

In the thermosetting sheet, it is preferable that the volatile component be a terpene compound.

A dicing die bonding film according to the present invention includes: a base layer; an adhesive layer laminated on the base layer to form a dicing tape; and a thermosetting sheet laminated on the adhesive layer of the dicing tape,

in which the thermosetting sheet is any one of the thermosetting sheets above.

BRIEF DESCRIPTION OF DRAWINGS

Fig. 1 is a cross-sectional view showing a configuration of a dicing die bonding film according to one embodiment of the present invention.

DETAILED DESCRIPTION OF THE PREFERRED EMBODIMENT

Hereinafter, a description will be given on one embodiment of the present invention.

[Thermosetting sheet]

A thermosetting sheet according to this embodiment includes a thermosetting resin, a thermoplastic resin, and conductive particles. The conductive particles herein mean particles having an electric conductivity measured according to JIS K 0130 (2008) of 100 μS/cm or less.

A mass % of the thermoplastic resin in 100 mass % (mass parts) of the thermosetting sheet is preferably 1 mass % or more and 30 mass % or less, more preferably 3 mass % or more and 15 mass % or less. A mass % of the thermoplastic resin in 100 mass % of the thermosetting sheet is preferably 0.5 mass % or more and 10 mass % or less, more preferably 1 mass % or more and 7 mass % or less. A mass % of the conductive particles in 100 mass % of the thermosetting sheet is preferably 60 mass % or more and 95 mass % or less, more preferably 80 mass % or more and 93 mass % or less. A mass ratio of the thermosetting resin in 100 mass % of the resins (i.e., the thermosetting resin and the thermoplastic resin) is preferably 30 mass % or more and 90 mass % or less, more preferably 50 mass % or more and 80 mass % or less.

Examples of the thermosetting resin include an epoxy resin, a phenol resin, an amino resin, an unsaturated polyester resin, a polyurethane resin, a silicone resin, and a thermosetting polyimide resin. Among these, an epoxy resin is preferably used.

Examples of the epoxy resin include the epoxy resins of bisphenol A type, bisphenol F type, bisphenol S type, brominated bisphenol A type, hydrogenated bisphenol A type, bisphenol AF type, biphenyl type, naphthalene type, fluorene type, phenol novolak type, cresol novolak type, ortho-cresol novolak type, trishydroxyphenylmethane type, tetraphenylolethane type, hydantoin type, trisglycidyl isocyanurate type, and glycidyl amine type. Among these, at least one of a bisphenol A type epoxy resin and a cresol novolak type epoxy resin is preferably used, and a bisphenol A type epoxy resin and a cresol novolak type epoxy resin are more preferably used in combination. Examples of the bisphenol A type epoxy resin include an aliphatic modified bisphenol A type epoxy resin.

Examples of the phenol resin as a curing agent for the epoxy resin include a novolak type phenol resin, a resol type phenol resin, a biphenyl type phenol resin, and a polyoxystyrene such as polyparaoxystyrene. Among the above phenol resins, a biphenyl type phenol resin is preferably used.

A thermoplastic resin having a thermosetting functional group can also be used as a thermosetting resin. Examples of the thermoplastic resin having a thermosetting functional group include a thermosetting functional group-containing acrylic resin. Examples of the acrylic resin in the thermosetting functional group-containing acrylic resin include an acrylic resin including a monomer unit derived from a (meth)acrylate ester. For the thermoplastic resin having a thermosetting functional group, a curing agent is selected depending on the kind of the thermosetting functional group.

The thermoplastic resin functions as a binder. Since the thermosetting sheet according to this embodiment includes a thermoplastic resin as a binder, the viscosity at 100 °C of the thermosetting sheet can be relatively easily adjusted to 20 kPa·s or more and 3000 kPa·s or less, which will be described later. Examples of the thermoplastic resin includes natural rubber, a butyl rubber, an isoprene rubber, a chloroprene rubber, an ethylene-vinyl acetate copolymer, an ethylene-acrylate copolymer, an ethylene-acrylate ester copolymer, a polybutadiene resin, a polycarbonate resin, a thermoplastic polyimide resin, a polyamide resin such as polyamide 6 or polyamide 6,6, a phenoxy resin, an acrylic resin, a saturated polyester resin such as PET or PBT, a polyamide-imide resin, and a fluororesin. These kinds of thermoplastic resins may be individually used, or two or more kinds of them may be used in combination. As the thermoplastic resin, an acrylic resin is preferable in terms of its small amount of ionic impurities and high heat resistivity allowing the thermosetting sheet to easily secure connection reliability.

The acrylic resin is preferably a polymer that includes a monomer unit derived from a (meth)acrylate ester as the largest monomer unit by mass ratio. Examples of the (meth)acrylate ester include (meth)acrylate alkyl ester, (meth)acrylate cycloalkyl ester, and (meth)acrylate aryl ester. The acrylic resin may include a monomer unit derived from other component copolymerizable with the (meth)acrylate ester. Examples of the other component include a carboxy group-containing monomer, an acid anhydride monomer, a hydroxy group-containing monomer, a glycidyl group-containing monomer, a sulfonic acid group-containing monomer, a phosphate group-containing monomer, a functional group-containing monomer such as acrylic amid or acrylonitrile, and various multifunctional monomers. The acrylic resin is preferably a carboxyl-containing acrylic rubber.

The conductive particles include silver particles having an average particle size $D_{50}$ of 0.01 $\mu$m or more and 10 $\mu$m or less and having a circularity in cross section in a thickness direction of 0.7 or more. Since the conductive particles include the silver particles having the average particle size $D_{50}$ of 10 $\mu$m or less, the outer surfaces of the silver particles can be molten to the extent sinterable at about a temperature at which the thermosetting resin is cured (for example 200 °C). The average particle size $D_{50}$ of the silver particles being 0.01 $\mu$m or more allows the silver particles to be relatively easily dispersed in the thermosetting sheet, and suppresses the surfaces of the silver particles from oxidization which easily occurs when the specific surface area of the silver particles is excessively large, thereby being capable of securing sufficient conductivity of the silver particles. This enables the silver particles having sufficient conductivity and in the state of being relatively dispersed to be molten to the extent that their outer surfaces are sinterable, and thus enables the conductive particles to be sintered together by the silver particles (or enables the silver particles to be sintered together in the case where the conductive particles are composed only of the silver particles). The silver particles having a circularity in cross section of 0.7 or more can be more sufficiently dispersed in the thermosetting sheet. Thus, the silver particles sufficiently dispersed in the thermosetting sheet enable the conductive particles to be sintered together (or enables the silver particles to be sintered together in the case where the conductive particles are composed only of the silver particles). As a result, the thermosetting sheet according to the present invention after being cured has high heat dissipation while having sufficient electric conductivity.

The average particle size $D_{50}$ of the silver particles is preferably 0.1 $\mu$m or more and 5 $\mu$m or less, more preferably 0.5 $\mu$m or more and 2 $\mu$m or less. The circularity of the silver particles in cross section in the thickness direction is preferably 0.8 or more. The upper limit value of the circularity is 1.

The average particle size $D_{50}$ of the silver particles can be measured using, for example, a laser diffraction and scattering type particle size distribution measuring apparatus (Microtrac MT3000II series manufactured by MicrotracBEL) on a volume basis.

The circularity is an index for obtaining shape complexity on the basis of an area value and a peripheral length value. Where the area is S and the peripheral length is L, the circularity is represented as $4\pi S/L^2$. The shape is a true circular shape when the circularity value is 1, and the smaller the circularity value is than 1, the less circular the shape becomes. The circularity can be obtained by cutting the thermosetting sheet in the thickness direction, capturing an SEM image of the cut surface, and analyzing the captured SEM image using a particle image analyzer (PITA-3, manufactured by SEISHIN ENTERPRISE CO., LTD.), specifically analyzing the image using image analysis software such as "ImageJ". The analysis using the particle image analyzer is performed for 10 randomly selected silver particles in the SEM image, and the circularity can be obtained by arithmetically averaging the circularity values obtained for the 10 silver particles. In the case where the thermosetting sheet includes conductive particles other than the silver particles, a reflected electron image is used in which portions having a certain composition are observed to be bright while others having a different composition are observed to be dark, to thereby enable the silver particles and the conductive particles other than the silver particles to be distinguished from each other.

The silver particles may be silver particles composed of the silver element and other elements (e.g., metal elements) included as inevitable impurity elements, or may be silver particles subjected to surface treatment (for example, silane coupling treatment). Examples of the surface treatment agent for the silver particles include coating agents that are aliphatic, amine-based, epoxy-based, and the like. Examples of the silver particles subjected to surface treatment with an aliphatic coating agent include HP02 and HP02A manufactured by MITSUI MINING & SMELTING CO., LTD., and examples of the silver particles treated with an epoxy-based coating agent include a modified product (epoxy-coated product) of HP02A manufactured by MITSUI MINING & SMELTING CO., LTD. In the thermosetting sheet according to this embodiment, it is preferable that the silver particles subjected to surface treatment with an epoxy-based coating agent be used. As aforementioned, the thermosetting sheet according to this embodiment include the thermosetting resin. Thus, in the case where silver particles subjected to surface treatment with an epoxy-based coating agent are used as the silver particles, the silver particles exhibit a relatively high affinity for the thermosetting resin in the thermosetting sheet, and are more easily dispersed in the thermosetting sheet. The more easily the silver particles are dispersed in the thermosetting sheet, the larger the amount of silver particles is included in the thermosetting sheet, to thereby enable the thermal conductivity (heat dissipation) of the thermosetting sheet to be improved. In the case where the surface treatment agent for the silver particles is an epoxy-based coating agent, the thermosetting resin included in the thermosetting sheet is preferably an epoxy resin. This configuration can further increase an affinity between the silver particles and the thermosetting resin, and thus enables the silver particles to be further dispersed in the thermosetting sheet. As a result, the thermal conductivity (heat dissipation) of the thermosetting sheet can be further increased.

The conductive particles may include nickel particles, copper particles, aluminum particles, carbon black, carbon nanotubes, particles formed by plating the surfaces of core metal particles with a metal such as gold or silver (hereinafter referred to also as plated metal particles), particles formed by coating the surfaces of core resin particles with a metal (hereinafter referred to also as metal-coated resin particles), and the like, other than the silver particles. These kinds of

conductive particles may be individually used, or two or more kinds of them may be used in combination.

As the plated metal particles, for example, particles in which nickel particles or copper particles serve as cores and the surfaces of the cores are plated with a noble metal such as gold or silver can be used. As the metal-coated resin particles, for example, particles in which resin particles serve as cores and the surfaces of the cores are coated with a metal such as nickel or gold can be used. In the case where the thermosetting sheet according to this embodiment includes conductive particles other than the silver particles, the plated metal particles are preferably used as the conductive particles, and particles in which copper particles serve as cores and the surfaces of the cores are plated with silver (silver-coated copper particles) are preferably used as the plated metal particles. Examples of the commercially available silver-coated copper particles include: product name 1200YP manufactured by MITSUI MINING & SMELTING CO., LTD.; and product name AOP-TCY-2 (EN) manufactured by DOWA Electronics Materials Co., Ltd. In the case where the thermosetting sheet according to this embodiment includes conductive particles other than the silver particles, the mass % of the silver particles in 100 mass % of the conductive particles is preferably 10 mass % or more and 95 mass % or less, more preferably 20 mass % or more and 90 mass % or less.

The shape of the conductive particles other than the silver particles may be, for example, a flake shape, a needle shape, a filament shape, a spherical shape, or a flat shape (including a scale-like shape), and is preferably a flat shape, which allows the conductive particles to have a large specific surface area capable of increasing their contact area with the silver particles. The aforementioned product 1200YP manufactured by MITSUI MINING & SMELTING CO., LTD. is conductive particles having a flat shape.

The conductive particles other than the silver particles have an average particle size $D_{50}$ of preferably 0.01 μm or more and 20 μm or less, more preferably 0.05 μm or more and 10 μm or less. The average particle size $D_{50}$ of the conductive particles other than the silver particles can be measured in the same manner as in the aforementioned average particles size $D_{50}$ of the silver particles.

The thermosetting sheet according to this embodiment may include a thermosetting catalyst in terms of sufficiently progressing the curing reaction of the resin component or increasing the curing reaction rate. Examples of the thermosetting catalyst include an imidazole-based compound, a triphenylphosphine-based compound, an amine-based compound, and a trihalogenborane-based compound.

The thermosetting sheet according to this embodiment has a viscosity at 100 °C of 20 kPa·s or more and 3000 kPa·s or less. The thermosetting sheet having a viscosity at 100 °C of 20 kPa·s or more and 3000 kPa·s or less can increase wettability to an adherend (for example, a semiconductor wafer), thereby being capable of relatively sufficiently securing adhesiveness to the adherend. Thus, separation of semiconductor devices can be relatively suppressed. In particular, when a thermosetting sheet attached to one side of a semiconductor wafer is diced to obtain a plurality of thermosetting sheets each having a semiconductor device attached to one side thereof, the separation of the semiconductor devices from the thermosetting sheets can be relatively suppressed.

The viscosity at 100 °C can be evaluated using a rheometer (a rotational rheometer HAAKE MARS manufactured by Thermo Fisher Scientific). Specifically, it can be obtained by reading an indicated value at 100 °C when temperature rises from 30 °C to 180 °C at a temperature rising rate of 10 °C/min.

The thermosetting sheet according to this embodiment may include a volatile component. The thermosetting sheet according to this embodiment includes preferably 5 mass % or more and 50 mass % or less, more preferably 10 mass % or more and 40 mass % or less, of the volatile component based on the total mass of the organic components (i.e., the thermosetting resin, the thermoplastic resin, and the volatile component) included in the thermosetting sheet. Examples of the volatile component can include an organic compound that includes one or more hydroxy groups and has a boiling point of 250 °C or higher. The boiling point of the organic compound is preferably 350 °C or less. Examples of such an organic compound may include a terpene compound. As the volatile component, isobornyl cyclohexanol expressed by a following formula (1) is preferable among terpene compounds. Isobornyl cyclohexanol is an organic compound with a boiling point of 308 to 318 °C, and has characteristics that, when heated under a nitrogen gas flow of 200 mL/min from room temperature (23 ± 2 °C) to 600 °C at a temperature rising rate of 10 °C/min, weight reduction becomes significant when the temperature reaches 100 °C and such significant weight reduction continues as the temperature increases, and volatilization and vanishment occurs (i.e., no further weight reduction is found) at 245 °C. Isobornyl cyclohexanol has further characteristics that it has an extremely high viscosity of 1,000,000 Pa -s at 25 °C but has a relatively low viscosity of 1000 mPa·s or less at 60 °C. The weight reduction refers to a value obtained when the weight reduction ratio at a measurement starting temperature (room temperature) is 0%. Isobornyl cyclohexanol exhibits an extremely high viscosity at 25 °C as aforementioned and thus can keep the thermosetting sheet in a sheet shape at room temperature, but at which it exhibits a relatively low viscosity at 60 °C as described above to have tackiness. That is, the thermosetting sheet including isobornyl cyclohexanol is excellent in capability of keeping itself in a sheet shape at room temperature, and has tackiness at 60 °C and higher. When a semiconductor device bonded to one side of the thermosetting sheet is mounted on a metal lead frame or the like, it is general that the semiconductor device is temporarily attached (fixed) to an adherend such as the metal lead frame via the thermosetting sheet at a temperature of 60 to 80 °C. In the case where the thermosetting sheet according to this embodiment includes, as the volatile component, isobornyl

cyclohexanol, which causes tackiness at 60 °C and higher as aforementioned, the temporary bonding of the thermosetting sheet to an adherend such as a metal lead frame is more improved. That is, the thermosetting sheet in the state of being temporarily bonded suppresses the semiconductor device from being displaced from its mounting position, and is suppressed from rising from the adherend. Thus, the semiconductor device can be reliably bonded to the adherend by heat-curing the thermosetting sheet.

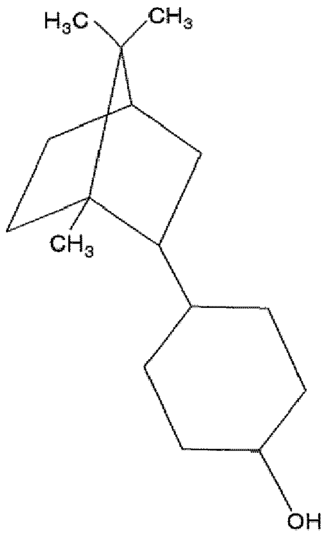

···(1)

In the thermosetting sheet according to this embodiment, the packing ratio P of the conductive particles in the thermosetting sheet before being cured is preferably 30 volume % or more, more preferably 40 volume % or more, further preferably 50 volume % or more. The packing ratio P of the particles is preferably 70 volume % or less, more preferably 60 volume % or less. The packing ratio P of the particles falling within the aforementioned value range can further increase heat dissipation of the cured thermosetting sheet.

The packing ratio P of the particles can be obtained with the following steps:

(1) The cured thermosetting sheet is mechanically polished to expose its cross section, and the exposed cross section is subjected to ion polishing using an ion polisher (for example, product name: Cross Section Polisher SM-09010 manufactured by JEOL, Ltd.).

(2) An SEM image (an image obtained by a scanning electron microscope) of a given cross-sectional area of the exposed cross section that has been ion-polished is captured using a field emission scanning electron microscope (for example, product name SU8020 manufactured by Hitachi High-Tech Corporation) at an accelerating voltage of 5 kV and at a magnification of 5000 times to obtain a reflected electron image as an image data.

(3) The obtained image data is subjected to automatic binarization processing, in which the data was binarized into a metal portion and a resin portion using image analysis software (for example, ImageJ).

(4) The total area of the conductive particles portion and the entire (conductive particles portion + resin portion) area are obtained from the binarized image, and the total area of the conductive particles portion is divided by the entire area to obtain the packing ratio P of the conductive particles in the cured thermosetting sheet.

It is preferable that the packing ratio P of the conductive particles be obtained by arithmetically averaging the packing ratios obtained for five cross-sectional areas in the exposed cross section that has been ion-polished.

The thermosetting sheet according to this embodiment has a thickness of preferably 5 μm or more, more preferably 10 μm or more, further preferably 20 μm or more. The thermosetting sheet has a thickness of preferably 150 μm or less, more preferably 100 μm or less, further preferably 80 μm or less. The thermosetting sheet having a thickness of 150 μm or less can have more improved thermal conductivity (heat dissipation). The thickness of the thermosetting sheet can be obtained by measuring the thickness thereof at any five positions selected at random using a dial gauge (model R-205 manufactured by PEACOCK), followed by arithmetically averaging these thickness values.

The thermosetting sheet according to this embodiment has a thermal conductivity after being cured of preferably 3 W/m·K or more, more preferably 10 W/m·K or more. The thermal conductivity after being cured falling within the above value range can further increase the conductivity of the cured thermosetting sheet. In the thermosetting sheet according to this embodiment, the upper limit of the thermal conductivity after being cured is generally 100 W/m·K. The thermal conductivity after being cured can be calculated using the equation below for a heat-cured thermosetting sheet obtained

by heat-curing the thermosetting sheet according to this embodiment using a pressure cooker apparatus under 0.5 MPa pressure at 200 °C for an hour:

$$\text{Thermal conductivity (W/m}\cdot\text{K)} = \text{Thermal diffusivity (m}^2\text{/s)} \times \text{Specific heat (J/g}\cdot{}^\circ\text{C)} \times \text{Specific weight (g/cm}^3\text{)}$$

The thermal diffusivity ($m^2/s$) in the above equation can be measured by the TWA method (temperature wave analysis, measuring instrument: ai-Phase Mobile manufactured by ai-Phase Co., Ltd.). The specific heat (J/g·°C) in the above equation can be measured by the DSC method. In the specific heat measurement, DSC6220 manufactured by SII NanoTechnology Inc. is used at a temperature rising rate of 10 °C/min and in a temperature range of 20 to 300 °C to obtain the data, based on which the specific heat can be calculated according to the method stipulated in the JIS handbook (Testing Methods for Specific Heat Capacity of Plastics: K-7123). Further, the specific weight in the above equation can be measured by the Archimedes method.

In the thermosetting sheet according to this embodiment, the peel strength for silicon wafer at room temperature (23 ± 2 °C) is preferably 1 N/10 mm or more, more preferably 5 N/10 mm or more, further preferably 10 N/10 mm or more. In the thermosetting sheet according to this embodiment, the peel strength for silicon wafer at room temperature (23 ± 2 °C) is preferably 20 N/10 mm or less, more preferably 15 N/10 mm or less. The peel strength for silicon wafer falling within the above value range can further suppress the separation of semiconductor devices during dicing. The peel strength for silicon wafer at room temperature can be measured by a peel test using a tensile tester (product name: AUTOGRAPH AG-X manufactured by Shimadzu Corporation) at room temperature (23 ± 2 °C), at a peeling angle of 180°, and at a tensile speed of 300 mm/min. Specifically, the measurement can be performed as follows:

(1) A thermosetting sheet is laid on one side of a silicon wafer (bare wafer) to obtain a laminated body.
(2) The laminated body is placed on a hot plate heated to 70 °C. The laminated body is placed so as to allow the surface of the silicon wafer to contact the surface of the hot plate.
(3) The laminated body is pressed using a pressure roller (with the roller weight of 2 kg) to attach the silicon wafer and the thermosetting sheet to each other, which is then left to stand on the hot plate for two minutes.
(4) The laminated body that has been left to stand is taken from the hot plate, and then left to stand at room temperature (23 ± 2 °C) for 20 minutes to obtain a test body.
(5) A peel test is performed for the test body under the above conditions using the above tensile tester to measure the peel strength for silicon wafer at room temperature.

The thermosetting sheet according to this embodiment may include one or more kinds of other components as needed. Examples of the other components include a filler dispersant, a flame retarder, a silane coupling agent, and an ion trapping agent.

[Dicing die bonding film]

Next, a description will be given on a dicing die bonding film 20 with reference to Fig. 1. Hereinafter, any description that has already been given for describing the thermosetting sheet will not be repeated.

As shown in Fig. 1, the dicing die bonding film 20 according to this embodiment includes a base layer 1, an adhesive layer 2 laminated on the base layer 1 to form a dicing tape 10, and a thermosetting sheet 3 laminated on the adhesive layer 2 of the dicing tape 10. The dicing die bonding film 20 has a semiconductor device attached on the thermosetting sheet 3. The semiconductor device may be a bare wafer. The bare wafer attached to the dicing die bonding film 20 according to this embodiment is cut into a plurality of bare chips by blade dicing, DBG (dicing before grinding) or SDBG (stealth dicing before grinding), or the like. The thermosetting sheet 3 is also cut at the time of the cutting of the bare wafer as above. The thermosetting sheet 3 is cut into pieces each having a size corresponding to the size of each of a plurality of bare chips formed into individual pieces. The plurality of bare chips to which the thermosetting sheet 3 is attached can be thus obtained.

As aforementioned, the thermosetting sheet 3 of the dicing die bonding film 20 is a thermosetting sheet including the thermosetting resin, the thermoplastic resin, and the conductive particles, in which the conductive particles include the silver particles having an average particle size $D_{50}$ of 0.01 μm or more and 10 μm or less, and having a circularity in cross section of 0.7 or more, the thermosetting sheet having a viscosity of 20 kPa·s or more and 3000 kPa·s or less.

The base layer 1 supports the adhesive layer 2, and the thermosetting sheet 3 laminated on the adhesive layer 2. The base layer 1 includes a resin. Examples of the resin include an olefin-based resin such as polyethylene (PE), polypropylene (PP), or ethylene-propylene copolymer; a copolymer including ethylene as a monomer component, such

as ethylene-vinyl acetate copolymer (EVA), an ionomer resin, ethylene-(meth) acrylate copolymer, or ethylene-(meth)acrylate ester (random or alternate) copolymer; a polyester such as polyethylene terephthalate (PET), polyethylene naphthalene (PEN), or polybutylene terephthalate (PBT); an acrylic resin; polyvinyl chloride (PVC); polyurethane; polycarbonate; polyphenylene sulfide (PPS); an amide-based resin such as polyamide or wholly aromatic polyamide (aramid); polyether ether ketone (PEEK); polyimide; polyether imide; polyvinylidene chloride; acrylonitrile butadiene styrene copolymer (ABS); a cellulose-based resin; a silicone resin; and a fluororesin. Among these, polyethylene terephthalate is preferably included in the base layer 1.

The base layer 1 may include one kind of the aforementioned resins, or may include two or more kinds of the aforementioned resins.

A material of the base layer 1 may be a crosslinked polymer or the like of any of the resins (for example, a plastic film). The plastic film may be used without being stretched, or may be subjected to uniaxial or biaxial stretching as needed for use. According to a resin sheet to which heat shrinkability is imparted by stretching or the like, a contact area between the adhesive layer 2 and the thermosetting sheet 3 can be reduced by causing the base layer 1 of the resin sheet to heat shrink after dicing, to thereby allow the semiconductor chips (semiconductor devices) to be easily collected.

A surface of the base layer 1 may be subjected to a general surface treatment to increase, for example, its tight adhesiveness to an adjacent layer, or its capability of being secured to the adjacent layer. Examples of the surface treatment include a chemical or physical treatment such as chromic acid treatment, ozone exposure, flame exposure, high-pressure electric shock exposure, or ionized radiation treatment; and coating treatment using a primer.

The base layer 1 has a thickness of preferably 1 μm or more and 1000 μm or less, more preferably 10 μm or more and 500 μm or less, further preferably 20 μm or more and 300 μm or less, particularly preferably 30 μm or more and 200 μm or less. The thickness of the base layer 1 can be obtained using a dial gauge (model R-205 manufactured by PEACOCK), as in the thickness of the thermosetting sheet 3 as aforementioned.

The base layer 1 may include various additives. Examples of the various additives include a colorant, a filler, a plasticizer, an aging retardant, an antioxidant, a surfactant, and a flame retarder.

An adhesive used for forming the adhesive layer 2 is not particularly limited, and for example a general pressure-sensitive adhesive such as an acrylic adhesive or a rubber adhesive can be used. The pressure-sensitive adhesive is preferably an acrylic adhesive including an acrylic polymer as a base polymer in terms of, for example, securing clean washability of electronic components such as semiconductor wafers or glasses, which should be kept away from contamination, using ultrapure water or an organic solvent such as an alcohol.

Examples of the acrylic polymer include an acrylic polymer that includes, as a monomer component, one or more kinds of a (meth)acrylate alkyl ester and a (meth)acrylate cycloalkyl ester. Examples of the (meth)acrylate alkyl ester can include a linear or branched alkyl ester having a 1-30C, particularly 4-18C alkyl group, such as methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, tridecyl ester, tetradecyl ester, hexadecyl ester, octadecyl ester, or eicosyl ester. Examples of the (meth)acrylate cycloalkyl ester can include cyclopentyl ester and cyclohexyl ester. The (meth)acrylate ester means at least one of the acrylate ester or the methacrylate ester, and the term (meth) herein is used in the same way as above throughout the specification.

The acrylic polymer may include a unit corresponding to another monomer component that is copolymerizable with the (meth)acrylate alkyl ester or the (meth)acrylate cycloalkyl ester, as appropriate, for the purpose of improving cohesive force, heat resistance, or the like. Examples of such a monomer component include: a carboxyl group-containing monomer such as acrylate, methacrylate, carboxyethyl (meth)acrylate, carboxypentyl (meth)acrylate, itaconic acid, maleic acid, fumaric acid, or crotonic acid; an acid anhydride monomer such as maleic anhydride or itaconic anhydride; a hydroxy group-containing monomer such as 2-hydroxythyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, or (4-hydroxymethyl cyclohexyl) methyl (meth)acrylate; a sulfonic acid group-containing monomer such as styrenesulfonic acid, arylsulfonic acid, 2-(meth)acrylamide-2-methylpropanesulfonic acid, (meth)acryloyloxynaphthalenesulfonic acid, or sulfopropyl (meth)acrylate; a phosphate group-containing monomer such as 2-hydroxyethyl acryloyl phosphate; acrylamide; and acrylonitrile. One or more kinds of these copolymerizable monomer components can be used. The amount of these copolymerizable monomers in use is preferably 40 mass % or less of the total monomer components.

The acrylic polymer can further include a multifunctional monomer or the like as a copolymerizing monomer component as needed for crosslinking. Examples of such a multifunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, tripmethylolpropane tri(meth)acrylate, pentaerythritol tri(meth)acrylate, dipentaerythritol hexa(meth)acrylate, epoxy (meth)acrylate, polyester (meth)acrylate, and urethane (meth)acrylate. One or more kinds of these multifunctional monomers can be used. The amount of these multifunctional monomers in use is preferably 30

mass % or less of the total monomer components in terms of, for example, their adhesion characteristics.

The acrylic polymer can be obtained by polymerizing a single monomer or two or more kinds of monomer mixtures. The polymerization may be performed by any of solution polymerization, emulsion polymerization, bulk polymerization, suspension polymerization, and the like. The acrylic polymer preferably has a small content of low-molecular weight substances in terms of, for example, preventing a clean adherend from contamination. In this regard, the number average molecular weight of the acrylic polymer is preferably 300,000 or more, more preferably about 400,000 to 3,000,000.

An external crosslinking agent can be appropriately added to the adhesive, in order to increase the number average molecular weight of the acrylic polymer or the like, which is the base polymer of the adhesive. Specific examples of the external crosslinking method include a method which includes adding a crosslinking agent such as a polyisocyanate compound, an epoxy compound, an aziridine compound, or a melamine-based crosslinking agent to the adhesive to cause a reaction. In the case where the external crosslinking agent is used, the amount of the external crosslinking agent in use is determined as appropriate, in consideration of the balance with the amount of the base polymer to be crosslinked and its intended use as the adhesive. Generally, the amount of the external crosslinking agent mixed with the base polymer is preferably about 5 parts by mass or less, more preferably 0.1 to 5 parts by mass based on 100 parts by mass of the base polymer.

In addition to the aforementioned components, the adhesive may include additives such as any known tackifier and aging retardant as appropriate.

The adhesive layer 2 can be formed of a radiation-curable adhesive. The radiation-curable adhesive can easily reduce its pressure-sensitive adhesiveness by being irradiated with radiation such as ultraviolet rays to increase the degree of crosslinking. That is, the adhesive layer 2 formed of the radiation-curable adhesive allows the thermosetting sheet 3 to be in sufficient contact with the adhesive layer 2 without being subjected to radiation irradiation before dicing, and reduces its pressure-sensitive adhesiveness by being subjected to radiation irradiation after dicing so that semiconductor chips (semiconductor devices) can be easily picked up or collected.

The radiation-curable adhesive is not particularly limited, and can be any adhesive as long as it has a radiation-curable functional group of a carbon-carbon double bond or the like, and exhibits pressure-sensitive adhesiveness. Examples of the radiation-curable adhesive include an additive-type radiation-curable adhesive in which a radiation-curable monomer component or oligomer component is mixed with a general pressure-sensitive adhesive such as an acrylic adhesive or a rubber adhesive.

Examples of the radiation-curable monomer component include urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, and 1,4-butanediol di(meth)acrylate. Examples of the radiation-curable oligomer component include a urethane-based oligomer, a polyether-based oligomer, a polyester-based oligomer, a polycarbonate-based oligomer, a polybutadiene-based oligomer, and various other oligomers, and any of these oligomers having a molecular weight of about 100 to 30,000 is preferable. The mixing amount of the radiation-curable monomer component or the radiation-curable oligomer component is preferably such an amount as to allow the adhesive layer 2 to appropriately reduce its pressure-sensitive adhesiveness after radiation irradiation. Generally, the mixing amount of the radiation-curable monomer component or the radiation-curable oligomer component is, for example, preferably 5 to 500 parts by mass, more preferably 40 to 150 parts by mass, based on the 100 parts by mass of the base polymer such as an acrylic polymer constituting the adhesive.

In addition to the additive-type radiation-curable adhesives mentioned above, the radiation-curable adhesive can be an intrinsic-type radiation-curable adhesive in which a polymer having a carbon-carbon double bond in a side chain or the main chain of the polymer or at a terminal of the main chain is used as the base polymer. The intrinsic-type radiation-curable adhesive does not need to include an oligomer component or the like, which is a low-molecular component, or includes a relatively small content of the oligomer component or the like. Thus, the use of the intrinsic-type radiation-curable adhesive suppresses the oligomer component or the like from migrating within the adhesive layer 2 over time. As a result, the adhesive layer 2 can have a relatively stable layer structure.

The base polymer having the carbon-carbon double bond is not particularly limited as long as it has a carbon-carbon double bond and has pressure-sensitive adhesiveness. Such a base polymer preferably has an acrylic polymer as the basic skeleton. Examples of the basic skeleton of the acrylic polymer include the aforementioned acrylic polymers.

A method for introducing the carbon-carbon double bond into the acrylic polymer is not particularly limited and various methods can be employed, but when adopting a method in which the carbon-carbon double bond is introduced in a polymer side chain, molecular design can be easily made. Examples of the method include a method in which a monomer having a functional group is in advance caused to copolymerize with the acrylic polymer, followed by subjecting a compound having the carbon-carbon double bond and a functional group that can react with the functional group of the monomer to a condensation reaction or an addition reaction in the state where the carbon-carbon double bond is kept radiation-curable.

Examples of the combination of the functional groups include: a carboxylic acid group and an epoxy group, a

carboxylic acid group and an aziridinyl group, and a hydroxy group and an isocyanate group. Among these combinations of the functional groups, a combination of a hydroxy group and an isocyanate group is preferable in terms of easy reaction tracking. In these combinations of the functional groups, any of the functional groups can be present on any side of the acrylic polymer and the compound having the carbon-carbon double bond, as long as the combination of the functional groups generates an acrylic polymer having the carbon-carbon double bond. In the case of the aforementioned preferable combination, however, it is preferable that the acrylic polymer have a hydroxy group and the compound having the carbon-carbon double bond have an isocyanate group. In this case, examples of the isocyanate compound having the carbon-carbon double bond include methacryloyl isocyanate, 2-methacryloyloxyethyl isocyanate, and m-isopropenyl-a,a-dimethylbenzyl isocyanate. Examples of the acrylic polymer include a polymer formed by copolymerizing an ether-based compound or the like such as the aforementioned hydroxy group-containing monomer, 2-hydroxyethyl vinyl ether, 4-hydroxybutyl vinyl ether, or diethylene glycol monovinyl ether.

In the intrinsic-type radiation-curable adhesive, the base polymer having the carbon-carbon double bond (in particular an acrylic polymer) may be individually used, but the radiation-curable monomer component or the radiation-curable oligomer component can be added in such an amount as not to impair the characteristics of the adhesive. The radiation-curable oligomer component or the like is included generally in the range of 30 parts or less by mass, preferably in the range of 1 to 10 parts by mass, based on 100 parts by mass of the base polymer.

The radiation-curable adhesive includes a photopolymerization initiator in the case of being cured by, for example, ultraviolet rays. Examples of the photopolymerization initiator include an $\alpha$-ketol-based compound such as 4-(2-hydroxyethoxy)phenyl(2-hydroxy-2-propyl) ketone, $\alpha$-hydroxy-$\alpha$,$\alpha$'-dimethylacetophenone, 2-methyl-hydroxypropiophenone, or 1-hydroxycyclohexyl phenyl ketone; an acetophenone-based compound such as methoxyacetophenone, 2,2-dimethoxy-2-phenylacetophenone, 2,2-diethoxyacetophenone, or 2-methyl-1-[4-(methylthio)-phenyl]-2-morpholinopropane-1; an benzoin ether-based compound such as benzoin ethyl ether, benzoin isopropyl ether, or anisoin methyl ether; a ketal-based compound such as benzil dimethylketal; an aromatic sulfonyl chloride-based compound such as 2-naphthalene sulfonyl chloride; a photoactive oxime-based compound such as 1-phenone-1,1-propanedione-2-(o-ethoxycarbonyl)oxime; a benzophenone-based compound such as benzophenone, benzoyl benzoic acid, or 3,3'-dimethyl-4-metoxybenzophenone; a thioxanthone-based compound such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, or 2,4-diisopropylthioxanthone; camphorquinone; halogenated ketone; acylphosphine oxide; and acylphosphonate. The mixing amount of the photopolymerization initiator is, for example, 0.05 to 20 parts by mass based on 100 parts by mass of an acrylic polymer as the base polymer constituting the adhesive.

Examples of the radiation-curable adhesive include a rubber or acrylic adhesive disclosed in JP S60-196956 A, which includes: a photopolymerizable compound such as an addition polymerizable compound having two or more unsaturated bonds or alkoxysilane having an epoxy group; and a photopolymerization initiator such as a carbonyl compound, an organic sulfur compound, a peroxide, amine, or an onium salt-based compound.

In the case where curing inhibition by oxygen occurs at the time of radiation irradiation, it is desirable to keep the surface of the radiation-curable adhesive layer 2 away from oxygen (air) using some method. For example, the method can be performed by covering the surface of the adhesive layer 2 with a separator, or by irradiating the surface of the adhesive layer 2 with radiation such as ultraviolet rays in a nitrogen gas atmosphere.

The thickness of the adhesive layer 2 is not particularly limited, but is preferably 1 to 50 $\mu$m, more preferably 2 to 30 $\mu$m, further preferably 5 to 25 $\mu$m, in terms of both preventing chipping of a chip cutting surface and achieving the capability of enabling the thermosetting sheet 3 to be secured to the adhesive layer 2 and kept in the secured state.

The matters disclosed herein include the following:

(1)

A thermosetting sheet including: a thermosetting resin; a thermoplastic resin; and conductive particles, in which the conductive particles include silver particles having an average particle size $D_{50}$ of 0.01 $\mu$m or more and 10 $\mu$m or less, and having a circularity in cross section of 0.7 or more, the thermosetting sheet having a viscosity at 100 °C of 20 kPa·s or more and 3000 kPa·s or less.

According to such a configuration in which the conductive particles include the silver particles having an average particle size $D_{50}$ of 10 $\mu$m or less, the outer surfaces of the silver particles can be molten to the extent sinterable at about a temperature at which the thermosetting resin is cured (for example 200 °C). The average particle size $D_{50}$ of the silver particles being 0.01 $\mu$m or more allows the silver particles to be relatively easily dispersed in the thermosetting sheet, and suppresses the surfaces of the silver particles from oxidization which easily occurs when the specific surface area of the silver particles is excessively large, thereby being capable of securing sufficient conductivity of the silver particles. This enables the silver particles having sufficient conductivity and in the state of being relatively dispersed to be molten to the extent that their outer surfaces are sinterable, and thus enables the conductive particles to be sintered together. The silver particles each having a circularity in cross section of 0.7 or more can be more sufficiently dispersed in the thermosetting sheet. Thus, the silver particles sufficiently dispersed in the thermosetting sheet enable the conductive particles to be sintered together. As a result, the thermosetting sheet according to the present invention after being cured

has high heat dissipation while having sufficient electric conductivity. Further, the viscosity at 100 °C of 20 kPa·s or more and 3000 kPa·s or less enables the thermosetting sheet to increase wettability to an adherend (for example, a semiconductor wafer), thereby being capable of relatively sufficiently securing adhesiveness to the adherend. The thermosetting sheet including the thermoplastic resin can have a viscosity at 100 °C relatively easily adjustable to fall within the above value range, and can further have relatively low elasticity after being cured. Thus, the separation of semiconductor devices can be relatively suppressed. As described above, the thermosetting sheet according to the present application can relatively suppress the separation of semiconductor devices, and has relatively high heat dissipation after being cured.

(2)

The thermosetting sheet of (1) above, in which a packing ratio P of the conductive particles in the cured thermosetting sheet is 30 volume % or more.

According to such a configuration, the cured thermosetting sheet can have even higher heat dissipation.

(3)

The thermosetting sheet of (2) above, in which the packing ratio P of the conductive particles in the cured thermosetting sheet is 70 volume % or less.

(4)

The thermosetting sheet of any of (1) to (3) above, in which a thermal conductivity after being cured is 3 W/m·k or more.

According to such a configuration, the cured thermosetting sheet can have an even higher electric conductivity.

(5)

The thermosetting sheet of (4) above, in which the thermal conductivity after being cured is 100 W/m·k or less.

(6)

The thermosetting sheet of any of (1) to (5) above, in which a peel strength for silicon wafer at room temperature is 1 N/10 mm or more.

According to such a configuration, the separation of semiconductor devices can be further suppressed.

(7)

The thermosetting sheet of (6) above, in which the peel strength for silicon wafer at room temperature is 20 N/10 mm or less.

(8)

The thermosetting sheet of any of (1) to (7) above, further including: a volatile component, in which the volatile component includes one or more hydroxy groups and has a boiling point of 250 °C or more.

According to such a configuration, the cured thermosetting sheet can have even higher heat dissipation.

(9)

The thermosetting sheet of (8) above, in which the volatile component is a terpene compound.

According to such a configuration, the cured thermosetting sheet can have even higher heat dissipation.

(10)

The thermosetting sheet of (9) above, in which the terpene compound is isobornyl cyclohexanol expressed by a formula (1) below:

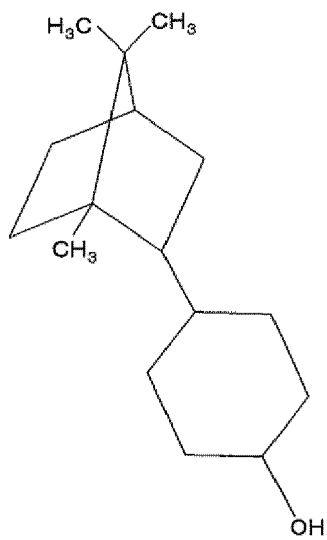

···(1)

According to such a configuration, the temporary bonding of the thermosetting sheet to an adherend such as a metal lead frame is more improved. That is, the thermosetting sheet in the state of being temporarily bonded suppresses the semiconductor device from being displaced from its mounting position, and is suppressed from rising from the

adherend. Thus, the semiconductor device can be reliably bonded to the adherend by heat-curing the thermosetting sheet.

(11)

A dicing die bonding film including: a base layer; an adhesive layer laminated on the base layer to form a dicing tape; and a thermosetting sheet laminated on the adhesive layer of the dicing tape, in which the thermosetting sheet is any of (1) to (10) above.

According to such a configuration, the dicing die bonding film includes the thermosetting sheet capable of relatively suppressing the separation of semiconductor devices, and having relatively high heat dissipation after being cured.

The thermosetting sheet and the dicing die bonding film according to the present invention are not limited to the aforementioned embodiment. The thermosetting sheet and the dicing die bonding film according to the present invention are not limited by the aforementioned operational advantages, either. Various modifications can be made for the thermosetting sheet and the dicing die bonding film according to the present invention without departing from the gist of the present invention.

## EXAMPLES

Hereinafter, the present invention will be more specifically described by way of examples. The following examples are provided for more specifically describing the present invention, and do not intend to limit the scope of the present invention.

### [Example 1]

A mixture of materials having the respective mass ratios shown in the column "Example 1" of Table 1 below was stirred using a hybrid mixer (product name: HM-500 manufactured by KEYENCE CORPORATION) for 3 minutes to prepare a varnish. The varnish was applied to one side of a release treatment film (product name: MRA38, with a thickness of 38 μm, manufactured by Mitsubishi Chemical Corporation), followed by being allowed to dry at 100 °C for 2 minutes to obtain a thermosetting sheet having a thickness of 30 μm. The materials shown in Table 1 below are as follows:

- Phenol resin
  MEHC-7851S (biphenyl type phenol resin, phenol equivalent of 209 g/eq), manufactured by MEIWA PLASTIC INDUSTRIES, LTD.
- Solid epoxy resin
  KI-3000-4 (cresol novolak type multifunctional epoxy resin, epoxy equivalent of 200 g/eq), manufactured by Nippon Steel & Sumikin Chemical Co., Ltd.
- Liquid epoxy resin
  EXA-4816 (aliphatic modified bisphenol A type epoxy resin (bifunctional type), epoxy equivalent of 403 g/eq), manufactured by DIC Corporation
- Silver (Ag)-coated copper (Cu) particles
  1200YP (flat copper particles coated with 10 mass % of silver particles, with the average particle size of 3.5 μm, irregular shapes), manufactured by MITSUI MINING & SMELTING CO., LTD.
- Silver (Ag) particles
  HP02A (silver particles subjected to surface treatment with an aliphatic coating agent), manufactured by MITSUI MINING & SMELTING CO., LTD.
- Volatile agent (isobornyl cyclohexanol (MTPH))
  MTPH manufactured by Nippon Terpene Chemicals, Inc.
- Acrylic resin solution
  TEISANRESIN SG-70L (including MEK and toluene as solvents, solid content of 12.5%, glass transition temperature of -13 °C, mass-average molecular weight of 900,000, acid value of 5 mg/KOH, carboxyl group-containing acrylic copolymer), manufactured by Nagase ChemteX Corporation
- Coupling agent
  KBE-846 (bis(triethoxysilylpropyl)tetrasulfide), manufactured by Shin-Etsu Chemical Co., Ltd.
- Catalyst
  TPP-K (tetraphenylphosphonium tetraphenylborate), manufactured by HOKKO CHEMICAL INDUSTRY CO., LTD.
- Solvent
  Methyl ethyl ketone (MEK)

Table 2 below shows the mass ratios respectively of the silver-coated copper particles and the silver particles

based on 100 mass parts of the conductive particles (silver-coated copper particles and silver particles), the mass ratio of the epoxy resin (solid and liquid) based on 100 mass parts of the thermosetting sheet, the mass ratio of the phenol resin based on 100 mass parts of the thermosetting sheet, the mass ratio of the acrylic resin based on 100 mass parts of the thermosetting sheet, and the mass ratio of isobornyl cyclohexanol based on 100 mass parts of the organic components (phenol resin, epoxy resin (solid and liquid), acrylic resin solution, and isobornyl cyclohexanol).

[Example 2]

A thermosetting sheet according to Example 2 was obtained in the same manner as in Example 1, except that a product with a modified coating agent (epoxy-coated product) of HP02A manufactured by MITSUI MINING & SMELTING CO., LTD. was included as the silver particles, no TPP-K was included as the catalyst, and a mixture of materials having the respective mass ratios shown in the column "Example 2" of Table 1 below was used.

[Example 3]

A thermosetting sheet according to Example 3 was obtained in the same manner as in Example 1, except that no TPP-K was included as the catalyst, and a mixture of materials having the respective mass ratios shown in the column "Example 3" of Table 1 below was used.

[Example 4]

A thermosetting sheet according to Example 4 was obtained in the same manner as in Example 1, except that HP02 manufactured by MITSUI MINING & SMELTING CO., LTD. was included as the silver particles, no TPP-K was included as the catalyst, and a mixture of materials having the respective mass ratios shown in the column "Example 4" of Table 1 below was used.

[Example 5]

A thermosetting sheet according to Example 5 was obtained in the same manner as in Example 1, except that AG-2-8F (silver particles subjected to surface treatment with an aliphatic coating agent) manufactured by DOWA Electronics Materials Co., Ltd. was included as the silver particles, AOP-TCY-2 (EN) manufactured by DOWA Electronics Materials Co., Ltd. was included as the silver (Ag)-coated copper (Cu) particles, and a mixture of materials having the respective mass ratios shown in the column "Example 5" of Table 1 below was used.

[Comparative Example 1]

A thermosetting sheet according to Comparative Example 1 was obtained in the same manner as in Example 1, except that SPH02J (aggregated Ag nanoparticles, irregular shapes, with the average particle size of aggregates of 1.8 μm), manufactured by MITSUI MINING & SMELTING CO., LTD. was included as the silver particles, no TPP-K was included as the catalyst, and a mixture of materials having the respective mass ratios shown in the column "Comparative Example 1" of Table 1 below was used.

[Comparative Example 2]

A thermosetting sheet according to Comparative Example 2 was obtained in the same manner as in Example 1, except that SPH02J manufactured by MITSUI MINING & SMELTING CO., LTD. was included as the silver particles, and a mixture of materials having the respective mass ratios shown in the column "Comparative Example 2" of Table 1 below was used.

[Comparative Example 3]

A thermosetting sheet according to Comparative Example 3 was obtained in the same manner as in Example 1, except that SPH02J manufactured by MITSUI MINING & SMELTING CO., LTD. was included as the silver particles, no volatile agent (isobornyl cyclohexanol) was included, and a mixture of materials having the respective mass ratios shown in the column "Comparative Example 3" of Table 1 below was used.

Table 1

| | Unit | Ex. 1 | Ex. 2 | Ex. 3 | Ex. 4 | Ex. 5 | C. Ex. 1 | C. Ex. 2 | C. Ex. 3 |
|---|---|---|---|---|---|---|---|---|---|
| Phenol resin | Mass parts | 1.58 | 0.98 | 0.98 | 1.05 | 0.74 | 1.16 | 1.85 | 2.03 |
| Solid epoxy resin | Mass parts | 1.02 | 0.65 | 0.65 | 0.69 | 0.49 | 0.92 | 1.49 | 1.64 |
| Liquid epoxy resin | Mass parts | 0.44 | 0.28 | 0.28 | 0.3 | 0.21 | 0.39 | 0.64 | 0.7 |
| Ag-coated Cu particles | Mass parts | 2.7 | 12.8 | 10.5 | 3.6 | 13.3 | 2.5 | 7.2 | 22.7 |
| Ag particles | Mass parts | 23.9 | 30 | 24.6 | 32.2 | 30.9 | 22.7 | 64.6 | 7.18 |
| Volatile agent | Mass parts | 1.08 | 1.17 | 1.17 | 1.26 | 0.72 | 1.52 | 4.28 | - |
| Acrylic resin solution | Mass parts | 10.4 | 6.55 | 6.55 | 7.01 | 11.6 | 8.49 | 47.89 | 15 |
| Coupling agent | Mass parts | 0.17 | 0.12 | 0.12 | 0.13 | 0.11 | 0.15 | 0.44 | 0.16 |
| Catalyst | Mass parts | 0.01 | - | - | - | 0.01 | - | 0.01 | 0.01 |
| MEK | Mass parts | 7.5 | 17 | 13 | 13 | 9.50 | 8.5 | 2.5 | 13 |

<Average particle size $D_{50}$ of silver (Ag) particles>

The average particle size $D_{50}$ of the silver particles before being mixed was measured using a laser diffraction and scattering type particle size distribution measuring apparatus (Microtrac MT3000II series manufactured by MicrotracBEL). The measured average particle size $D_{50}$ of the silver particles included in the thermosetting sheet according to each of Examples and Comparative Examples is shown in Table 2 below.

<Circularity of silver (Ag) particles>

The circularity was obtained by cutting the thermosetting sheet according to each of Examples and Comparative Examples in the thickness direction, capturing an SEM image of the cut surface, and analyzing the captured SEM image using a particle image analyzer (PITA-3 manufactured by SEISHIN ENTERPRISE CO., LTD.). The analysis using the particle image analyzer was performed for 10 randomly selected silver particles in the SEM image, and the circularity was obtained by arithmetically averaging the circularity values obtained for the 10 silver particles. In the thermosetting sheet according to each of Examples and Comparative Examples, the silver particles and the silver (Ag)-coated copper (Cu) particles were distinguished from each other using a reflected electron image in which portions having a certain composition were observed to be bright while others having a different composition were observed to be dark. The circularity of the silver particles obtained for the thermosetting sheet according to each of Examples and the Comparative Examples is shown in Table 2 below.

<Packing ratio of conductive particles>

The packing ratio P of the particles was obtained for the thermosetting sheet according to each of Examples and Comparative Examples with the following steps:

(1) The cured thermosetting sheet is mechanically polished to expose its cross section, and the exposed cross section is subjected to ion polishing using an ion polisher (for example, product name: Cross Section Polisher SM-09010 manufactured by JEOL, Ltd.).
(2) An SEM image (an image obtained by a scanning electron microscope) of a given cross-sectional area of the exposed cross section that had been ion-polished is captured using a field emission scanning electron microscope SU8020 (manufactured by Hitachi High-Tech Corporation) at an accelerating voltage of 5 kV and at a magnification of 5000 times to obtain a reflected electron image as an image data.
(3) The obtained image data is subjected to automatic binarization processing, in which the data was binarized into a metal portion and a resin portion using ImageJ, image analysis software.
(4) The total area of the metal portion and the entire (metal portion + resin portion) area are obtained from the binarized image, and the total area of the metal portion is divided by the entire area to obtain the packing ratio P of the conductive particles in the cured thermosetting sheet.

The packing ratio P of the conductive particles was obtained by arithmetically averaging the packing ratios

obtained for five cross-sectional areas in the exposed cross section that had been ion-polished. The packing ratio P of the conductive particles obtained for the thermosetting sheet according to each of Examples and Comparative Examples is shown in Table 2 below.

<Viscosity at 100 °C of thermosetting sheet>

The viscosity at 100 °C of the thermosetting sheet according to each of Examples and Comparative Examples was evaluated using a rheometer (a rotational rheometer HAAKE MARS manufactured by Thermo Fisher Scientific). Specifically, it was obtained by reading an indicated value at 100 °C when temperature rose from 30 °C to 180 °C at a temperature rising rate of 10 °C/min. The viscosity at 100 °C obtained for the thermosetting sheet according to each of Examples and Comparative Examples is shown in Table 2 below.

<Thermal conductivity of thermosetting sheet>

The thermosetting sheet according to each of Examples and Comparative Examples was heat-cured using a pressure cooker apparatus under 0.5 MPa pressure at 200 °C for an hour. The thermal conductivity for the heat-cured thermosetting sheet according to each of Examples and Comparative Examples was calculated using the equation below:

$$\text{Thermal conductivity (W/m}\cdot\text{K)} = \text{Thermal diffusivity (m}^2\text{/s)} \times \text{Specific heat (J/g}\cdot{}^\circ\text{C)} \times \text{Specific weight (g/cm}^3\text{)}$$

The thermal diffusivity $\alpha$ ($m^2/s$) was measured by the TWA method (temperature wave analysis, measuring instrument: ai-Phase Mobile manufactured by ai-Phase Co., Ltd.). The specific heat Cp (J/g · °C) was measured by the DSC method. In the specific heat measurement, DSC6220 manufactured by SII NanoTechnology Inc. was used at a temperature rising rate of 10 °C/min and in a temperature range of 20 to 300 °C to obtain the data, based on which the specific heat was calculated according to the method stipulated in the JIS handbook (Testing Methods for Specific Heat Capacity of Plastics: K-7123). Specific weight was measured by the Archimedes method. The calculated thermal diffusivity for the cured thermosetting sheet according to each of Examples and Comparative Examples is shown in Table 2 below.

<Peel strength from silicon wafer>

The adhesive force to a silicon wafer was measured for the thermosetting sheet according to each of Examples and Comparative Examples. The peel strength from a silicon wafer was measured at room temperature (23 ± 2 °C). The peel strength from a silicon wafer was measured by a peel test using a tensile tester (product name: AUTOGRAPH AG-X manufactured by Shimadzu Corporation) at room temperature (23 ± 2 °C), at a peeling angle of 180°, and at a tensile speed of 300 mm/min. Specifically, the measurement was performed as follows:

(1) A thermosetting sheet is laid on one side of a silicon wafer (bare wafer) to obtain a laminated body.
(2) The laminated body is placed on a hot plate heated to 70 °C. The laminated body is placed to allow the surface of the silicon wafer to contact the surface of the hot plate.
(3) The laminated body is pressed using a pressure roller (with the roller weight of 2 kg) to attach the silicon wafer and the thermosetting sheet to each other, and then left to stand on the hot plate for two minutes.
(4) The laminated body that has been left to stand is taken from the hot plate, and then left to stand at room temperature (23 ± 2 °C) for 20 minutes to obtain a test body.
(5) A peel test is performed under the above conditions using the above tensile tester to measure the peel strength of the test body from a silicon wafer at room temperature.

The peel strength for silicon wafer measured for the thermosetting sheet according to each of Examples and Comparative Examples is shown in Table 2.

<Separation resistance during dicing>

Separation resistance during dicing was evaluated using a bare wafer and a dicing die bonding film in which a thermosetting sheet was laminated on an adhesive layer of a dicing tape. Specifically, the evaluation was conducted with the following steps:

(1) An Si bare wafer having a thickness of 100 μm and a dimeter of 8 inches (200 mm) is attached to the thermosetting sheet while being in pressing contact therewith using a pressing device (pressure roller).
(2) The thermosetting sheet and the Si bare wafer were subjected to blade dicing using a fully automatic dicing saw (FULLY AUTOMATIC DICING SAW, DFD6361 manufactured by DISCO Corporation), at a spindle rotation of 45000 rpm ($min^{-1}$), a feeding speed of 30 mm/s, and a pitch of 5 mm, to obtain a plurality of thermosetting sheets each having a bare chip laminated thereon. Separation resistance during dicing is judged to be good if there finds no bare chip separated from the thermosetting sheet at a practically problematic level, and is judged to be poor if there finds any bare chip separated (coming off) from the thermosetting sheet at a practically problematic level.

The adhesive layer, the dicing tape, and the dicing die bonding film were prepared as follows.

(Preparation of adhesive layer)

Synthesizing acrylic polymer

The materials below were put into a reaction vessel including a cooling pipe, a nitrogen introducing pipe, a thermometer, and a stirrer so as to have a monomer concentration of about 55 mass %, followed by being subjected to polymerization reaction under nitrogen gas flow at 60 °C for 10 hours. An acrylic polymer intermediate was thereby synthesized.

- 2-ethylhexyl acrylate (2HEA): 100 mass parts
- 2-hydroxyethyl acrylate (HEA): 20 mass parts
- Polymerization initiator: Appropriate amount
- Polymerization solvent: Toluene

Under the presence of dibutyltin dilaurate (0.1 mass part), 100 mass parts of the synthesized acrylic polymer intermediate and 1.4 mass part of 2-methacryloyloxyethyl isocyanate (MOI) were subjected to addition reaction in air flow at 50 °C for 60 hours to synthesize an acrylic polymer.

Preparing adhesive layer

(1) A solution including the materials below is obtained, and toluene is appropriately added to the solution to thereby prepare an adhesive solution having a viscosity of 500 mPa·s:

- Synthesized acrylic polymer: 100 mass parts
- Polyisocianate compound
  (Product name "CORONATE L", manufactured by Nippon Polyurethane Industry Co.,Ltd.): 1.1 mass part
- Photopolymerization initiator
  (Product name "Irgacure 184" manufactured by Ciba Specialty Chemicals): 3 mass parts

(2) A PET film is prepared as a release sheet. The adhesive solution prepared as above is applied to one side of the release sheet using an applicator. The one side of the release sheet (PET-based film) is subjected to silicon treatment as release treatment. After the application, it is subjected to drying treatment by heating at 120 °C for 2 minutes to prepare an adhesive layer having a thickness of 30 μm on the release sheet.

(Preparation of dicing tape and dicing die bonding film)

Preparing dicing tape

A support base composed of a polyethylene film having a thickness of 80 μm was attached to an exposed surface of the adhesive layer prepared on the release sheet using a laminator at room temperature to prepare a dicing tape. A portion of the adhesive layer of the dicing tape to which an Si bare wafer having a diameter of 8 inches was to be attached was irradiated with ultraviolet rays having an intensity of 300 $mJ/cm^2$ to ultraviolet-cure the portion.

Preparing dicing die bonding film

A thermosetting sheet was arranged on the ultraviolet-cured adhesive layer of the dicing tape so as to be in contact with a surface of the adhesive layer opposite to the surface on which the release sheet was laminated. Then, the thermosetting sheet and the dicing tape were fed through a laminator at a speed of 0.8 mm/min to attach the thermosetting sheet to the dicing tape, followed by removing the release sheet to prepare a dicing die bonding film in which the thermosetting sheet was laminated on the dicing tape.

The separation resistance during dicing evaluated for the thermosetting sheet according to each of Examples and Comparative Examples is shown in Table 2 below.

Table 2

| | | | Ex. 1 | Ex. 2 | Ex. 3 | Ex. 4 | Ex. 5 | C. Ex. 1 | C. Ex. 2 | C. Ex. 3 |
|---|---|---|---|---|---|---|---|---|---|---|
| Conductive particles | Ag particles | Mass ratio [mass parts] | 90 | 70 | 90 | 30 | 70 | 24 | 90 | 24 |
| | | Ag particle type | HP02A | HP02A | HP02A | HP02 | AG-2-8F | SPH02J | SPH02J | SPH02J |
| | | Ave. particle size $D_{50}$ of Ag particles [μm] | 1.1 | 1.1 | 1.1 | 0.6 | 0.9 | 2.1 | 2.1 | 2.1 |
| | | Ag particle circularity | 0.81 | 0.81 | 0.81 | 0.84 | 0.87 | 0.66 | 0.66 | 0.66 |
| | | Coating agent type of Ag particles | Aliphatic | Epoxy -based | Aliphatic | Aliphatic | Aliphatic | Epoxy -based | Epoxy -based | Epoxy -based |
| | Ag-coated Cu particles | Mass ratio [mass parts] | 10 | 30 | 10 | 70 | 30 | 76 | 10 | 76 |
| | | Ag-coated Cu type | 1200YP | 1200YP | 1200YP | 1200YP | AOP-TCY-2 (EN) | 1200YP | 1200YP | 1200YP |
| Thermosetting resin | | Epoxy resin [mass parts] | 4.55 | 1.97 | 2.36 | 2.46 | 1.46 | 4.32 | 2.47 | 6.44 |
| | | Phenol resin [mass parts] | 4.91 | 2.1 | 2.52 | 2.63 | 1.55 | 3.81 | 2.14 | 5.6 |
| | | Total mass parts of thermosetting resin | 9.46 | 4.07 | 4.88 | 5.09 | 3.01 | 8.13 | 4.61 | 12.04 |
| Thermoplastic resin | | Acrylic resin [mass parts] | 4.05 | 1.75 | 2.09 | 2.19 | 3.01 | 3.48 | 6.92 | 5.16 |
| Volatile component | | Isobornyl cyclohexanol [mass parts] | 20 | 30 | 20 | 30 | 20 | 30 | 30 | 0 |
| Packing ratio of particles in cured thermosetting sheet [volume %] | | | 35 | 55 | 40 | 48 | 58 | 42 | 35 | 38 |
| Viscosity of thermosetting sheet at 100 °C [kPa ▪ s] | | | 47 | 157 | 1084 | 2579 | 227 | 3385 | 5587 | 793 |
| Thermal conductivity of cured thermosetting sheet [W/m ▪ K] | | | 4.4 | 21.7 | 10.9 | 12.6 | 16 | 3.9 | 8.9 | 1.5 |
| Peeling strength from silicon wafer [N/10 mm] | | | 1.97 | 10.48 | 1.95 | 12.85 | 6.99 | 0.6 | 0.09 | 7.63 |
| Separation resistance during dicing | | | Good | Good | Good | Good | Good | Poor | Poor | Good |

It is found from Table 2 that the thermosetting sheet according to each of Examples includes, as the conductive particles, the silver particles having an average particle size $D_{50}$ of 0.01 μm or more and 10 μm or less and having a circularity in cross section of 0.7 or more, and has a viscosity at 100 °C falling within a range of 20 kPa·s or more and 3000 kPa·s or less. The thermosetting sheet according to each of Examples has a thermal conductivity after being cured of 3 W/m·K or more, which exhibits practically sufficient heat dissipation, and has a peeling strength from a silicon wafer of as relatively high as 1.0 N/10 mm or more, thus being evaluated to have good separation resistance during dicing.

In contrast, it is found that the thermosetting sheet according to each of Comparative Examples 1 and 2 includes the silver particles having a circularity in cross section of less than 0.7, and has a viscosity at 100 °C of more than 3000 kPa·s. The thermosetting sheet according to each of Comparative Examples 1 and 2 has a thermal conductivity after being cured of 3 W/m·K or more, which exhibits practically sufficient heat dissipation, but has a peeling strength from a silicon wafer of less than 1.0 N/10 mm or more, thus being evaluated to have poor separation resistance during dicing. It is also found that the thermosetting sheet according to Comparative Example 3 includes the silver particles having a circularity in cross section of less than 0.7, and has a viscosity at 100 °C falling within a range of 20 kPa·s or more and 3000 kPa·s or less. The thermosetting sheet according to Comparative Example 3 has a peeling strength from a silicon wafer of as relatively high as 7.63 N/10 mm, thus being evaluated to have good separation resistance during dicing, but has a thermal conductivity of 1.5 W/m·K, which does not exhibit practically sufficient heat dissipation.

It is found from these results that the thermosetting sheet that includes, as the conductive particles, the silver particles having an average particle size $D_{50}$ of 0.01 μm or more and 10 μm or less and having a circularity in cross section of 0.7 or more, and that has a viscosity at 100 °C falling within a range of 20 kPa·s or more and 3000 kPa·s or less can relatively suppress the separation of semiconductor devices during dicing and can have relatively high heat dissipation after being cured.

REFERENCE SIGNS LIST

- 1: Base layer
- 2: Adhesive layer
- 3: Thermosetting sheet
- 10: Dicing tape
- 20: Dicing die bonding film

## Claims

**1.** A thermosetting sheet comprising:

a thermosetting resin;
a thermoplastic resin; and
conductive particles, wherein
the conductive particles comprise silver particles having an average particle size $D_{50}$ of 0.01 μm or more and 10 μm or less, and having a circularity in cross section of 0.7 or more,
the thermosetting sheet having a viscosity at 100 °C of 20 kPa·s or more and 3000 kPa·s or less.

**2.** The thermosetting sheet according to claim 1, wherein
a packing ratio P of the conductive particles in the cured thermosetting sheet is 30 volume % or more.

**3.** The thermosetting sheet according to claim 1 or 2, wherein
a thermal conductivity after being cured is 3 W/m·k or more.

**4.** The thermosetting sheet according to any one of claims 1 to 3, wherein
a peel strength for silicon wafer at room temperature is 1 N/10 mm or more.

**5.** The thermosetting sheet according to any one of claims 1 to 4, further comprising:

a volatile component, wherein
the volatile component comprises one or more hydroxy groups and has a boiling point of 250 °C or more.

**6.** The thermosetting sheet according to claim 5, wherein the volatile component is a terpene compound.

**7.** A dicing die bonding film comprising:

a base layer;
an adhesive layer laminated on the base layer to form a dicing tape; and
a thermosetting sheet laminated on the adhesive layer of the dicing tape, wherein
the thermosetting sheet is the thermosetting sheet according to any one of claims 1 to 6.

FIG. 1

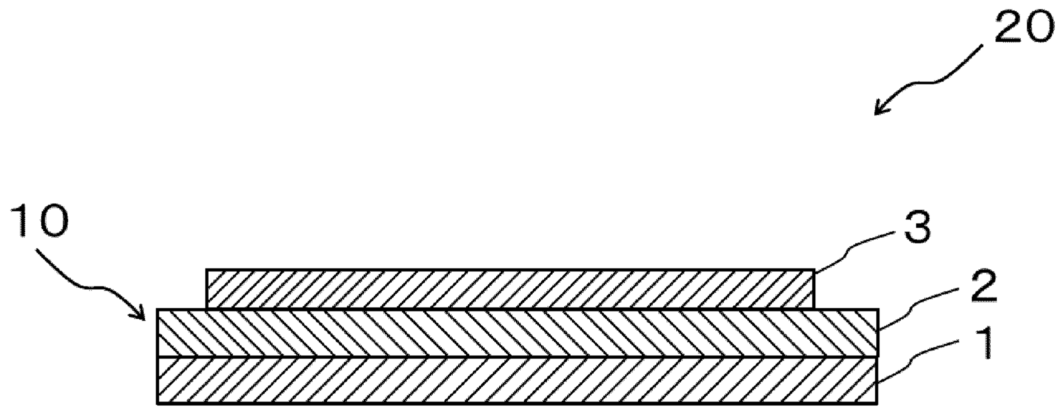

Europäisches Patentamt
European Patent Office
Office européen des brevets

# EUROPEAN SEARCH REPORT

Application Number
EP 21 18 0458

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2016 103524 A (NITTO DENKO CORP) 2 June 2016 (2016-06-02)<br>* abstract *<br>* paragraphs [0015], [0033] - paragraphs [0047], [0055], [0062], [0122]; claims 1-5,8-10; table 1 *<br>----- | 1-7 | INV.<br>C09J7/35<br>C09J7/10<br>C08K7/18<br>H01L23/00 |
| X | US 2012/061805 A1 (AMANO YASUHIRO [JP] ET AL) 15 March 2012 (2012-03-15)<br>* abstract *<br>* paragraphs [0007], [0070], [0072], [0082] - paragraphs [0087], [0092], [0098]; claims 1,2; example 2 *<br>----- | 1-7 | |

TECHNICAL FIELDS SEARCHED (IPC)

C09J
C08K
H01L

The present search report has been drawn up for all claims

1

| Place of search | Date of completion of the search | Examiner |
|---|---|---|
| Munich | 11 November 2021 | Meier, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

**ANNEX TO THE EUROPEAN SEARCH REPORT ON EUROPEAN PATENT APPLICATION NO.** EP 21 18 0458

This annex lists the patent family members relating to the patent documents cited in the above-mentioned European search report. The members are as contained in the European Patent Office EDP file on
The European Patent Office is in no way liable for these particulars which are merely given for the purpose of information.

11-11-2021

| Patent document cited in search report | Publication date | Patent family member(s) | Publication date |
|---|---|---|---|
| JP 2016103524 A | 02-06-2016 | CN 105647405 A | 08-06-2016 |
| | | JP 6396189 B2 | 26-09-2018 |
| | | JP 2016103524 A | 02-06-2016 |
| | | KR 20160063985 A | 07-06-2016 |
| | | TW 201631674 A | 01-09-2016 |
| US 2012061805 A1 | 15-03-2012 | CN 102399505 A | 04-04-2012 |
| | | JP 5580701 B2 | 27-08-2014 |
| | | JP 2012060068 A | 22-03-2012 |
| | | KR 20120028253 A | 22-03-2012 |
| | | TW 201212117 A | 16-03-2012 |
| | | US 2012061805 A1 | 15-03-2012 |
| | | US 2014057100 A1 | 27-02-2014 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019021813 A
- JP S60196956 A